# EUROPEAN PATENT APPLICATION

(11) **EP 3 855 197 A1**
(43) Date of publication of application: **28.07.2021**
(21) Application number: 21150400.6
(22) Date of filing: 06.01.2021
(51) Int. Cl.: G01R 31/371, G01R 31/3828

(54) **STATE OF CHARGE MEASUREMENT APPARATUS**

(30) Priority: 22.01.2020 JP 2020008263
(71) Applicant: Toshiba TEC Kabushiki Kaisha, Tokyo 141-8562 (JP)
(72) Inventor: Ishikawa, Hiroyuki, Shinagawa-ku, Tokyo 141-8562 (JP); Kato, Masakazu, Shinagawa-ku, Tokyo 141-8562 (JP)
(74) Representative: Bandpay & Greuter

(57) **Abstract**

A measurement apparatus includes a measurement circuit configured to measure a first current that flows to an electricity storage device and a second current that flows from the storage device, and a processor configured to detect one of a first state, in which the storage device is fully charged, and a second state, in which the storage device is fully discharged. The processor is configured to, upon detection of one of the first and second states, control the measurement circuit to start the measurement of the first current and the second current, calculate a remaining amount of power of the storage device using the measured first current and the measured second current, and output the calculated remaining amount of power.

## Description

### FIELD

Embodiments described herein relate generally to a measurement apparatus, a measurement system, and a cart.

### BACKGROUND

A shopping cart to which a tablet-type point of sale (POS) terminal is attached (hereinafter referred to as the "cart POS") is known. The cart POS may be equipped with an external battery in order to extend its operation time. However, such a cart POS may not have a function to measure the remaining battery level of the external battery, and the terminal may thus run out of battery while the cart POS is being used by customer. Some external batteries have a function to display the remaining level thereof, but when such a battery is built into a secondary casing or structure of the cart, then the battery-level display might no longer be visible to a cart user.

### DESCRIPTION OF THE DRAWINGS

FIG. 1 is a perspective view illustrating a cart system according to an embodiment.
FIG. 2 is a block diagram illustrating a terminal device according to an embodiment.
FIG. 3 is a circuit configuration diagram of a cart system according to an embodiment.
FIG. 4 is a flowchart of processing by a processor of a power receiving device according to an embodiment.
FIG. 5 is a flowchart of processing by a processor of a terminal device according to an embodiment.

### DETAILED DESCRIPTION

In one embodiment, a measurement apparatus includes a measurement circuit configured to measure a first current that flows to an electricity storage device and a second current that flows from the electricity storage device. The measurement apparatus further includes a processor configured to detect at least one of a first state, in which the electricity storage device is fully charged, and a second state, in which the electricity storage device is fully discharged. The processor is further configured to, upon detection of said one of the first and second states, control the measurement circuit to start measurement of the first current and the second current, calculate a remaining amount of charge in the electricity storage device based on the measured first current and the measured second current, and output the calculated remaining amount of charge.

Preferably, the measurement apparatus further comprises an electromagnetic induction coil, wherein the measurement circuit measures the first current flowing from the electromagnetic induction coil to the electricity storage device.

Preferably, the measurement apparatus further comprises a memory that stores a storage capacity value for the electricity storage device.

Preferably still, the remaining amount of charge of the electricity storage device is calculated based on the storage capacity value stored in the memory.

Preferably, the processor is configured to: detect both the first and second states, and calculate the storage capacity value using time-integrated values of the first current and the second current as measured for a change between the first and second states.

Preferably, the measurement apparatus further comprises a wireless communication circuit, wherein the processor is further configured to control the wireless communication circuit to transmit the calculated remaining amount of charge to a terminal device.

Preferably, the measurement apparatus further comprises an output interface circuit connected to the measurement circuit, wherein the first current flows through the output interface circuit to the electricity storage device.

Preferably, the electricity storage device is a battery.

There is also provided a measurement system comprising a terminal device, and the measurement apparatus as described above.

Preferably, the terminal device is configured to display the remaining amount of charge.

Preferably, the measurement system further comprises a body frame to which the terminal device, the measurement apparatus, and the electricity storage device are attached.

Preferably, the measurement system further comprises wheels attached to the body frame.

There is also provided a cart, comprising: a body frame to which wheels are attached; a terminal device attached to the body frame; a battery which is the electricity storage device configured to supply power to the terminal device; and the measurement apparatus as described above, attached to the body frame, wherein the terminal device is configured to display the calculated remaining amount of power.

In the following, a cart system according to one or more embodiments will be described with reference to the accompanying drawings. In each drawing, the scale of each part may be appropriately changed. In each drawing, some elements may be omitted for illustration purpose. In each drawing and this specification, the same reference numerals denote the same elements.

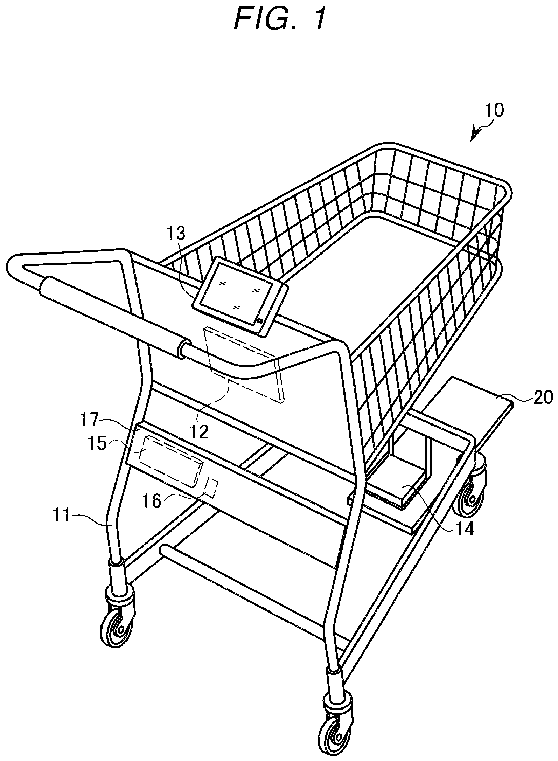

FIG. 1 is a perspective view of a cart system 1 according to an embodiment. The cart system 1 includes a shopping cart 10 and a power transmitting device 20. FIG. 1 illustrates the shopping cart 10 located above the power transmitting device 20 installed on the floor of a store. For illustration purpose, only one shopping cart 10 and one power transmitting device 20 are shown in FIG. 1. However, the cart system 1 may include a plurality of shopping carts 10 and a plurality of power transmitting devices 20.

The shopping cart 10 is a cart on which merchandise (items and commodities for sale) can be put and which is used by a shopper or the like in a store such as a supermarket. The shopping cart 10 is a shopping cart for the cart POS in which the shopper scans a commodity for sales transaction registration by himself or herself and then places the now registered commodity on the shopping cart. With such a configuration, there is no need for registration at a cash register. In an embodiment, the shopping cart 10 includes a cart body 11, a scanner 12, a terminal device 13, a power receiving device 14, a mobile battery 15, and a current detection circuit 16.

The cart body 11 has a body frame in which commodities are placed and for holding the scanner 12, the terminal device 13, the power receiving device 14, the mobile battery 15, and the current detection circuit 16. The body frame can hold a shopping basket above the power receiving device 14. The cart body 11 also includes wheels for movement, and the like.

The scanner 12 reads a barcode or a two-dimensional code attached to a commodity, and outputs a commodity code represented by the barcode or the two-dimensional code. Alternatively, the scanner 12 reads a wireless tag such as a radio frequency identifier (RFID) tag attached to a commodity or the like, and outputs the commodity code stored in this wireless tag. The commodity code output by the scanner 12 is input to the terminal device 13. The scanner 12 may be a hand-held type scanner, or may be a scanner fixed to the cart body 11. The scanner 12 may be integrated into the terminal device 13.

In one embodiment, the terminal device 13 is a tablet terminal such as a tablet personal computer (PC). Alternatively, the terminal device 13 may be a smartphone or any other computing device.

The power receiving device 14 wirelessly receives the power transmitted by the power transmitting device 20.

The mobile battery 15 supplies power to each device such as the scanner 12 and the terminal device 13 mounted on the shopping cart 10. The shopping cart 10 may be equipped with, for example, a printer. The mobile battery 15 is charged using the power received by the power receiving device 14. In general, the mobile battery 15 may be any commercially available battery.

The current detection circuit 16 is a circuit that measures an amount of current output by the mobile battery 15. The mobile battery 15 and the current detection circuit 16 are, for example, in a casing 17 of the cart body 11.

The power transmitting device 20 wirelessly transmits power to the power receiving device 14. The power transmitting device 20 transmits power to the power receiving device 14 by electromagnetic induction, but other methods may be used.

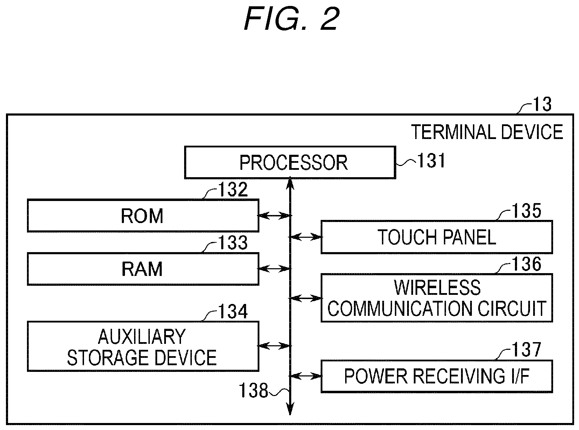

The terminal device 13 will be further described with reference to FIG. 2. FIG. 2 is a block diagram of the terminal device 13.

In one embodiment, the terminal device 13 includes a processor 131, a read-only memory (ROM) 132, a random-access memory (RAM) 133, an auxiliary storage device 134, a touch panel 135, a wireless communication circuit 136, and a power receiving interface (I/F) 137. Then, a bus 138 or the like connects these components to each other.

The processor 131 performs processing such as an operation and control necessary for the operation of the terminal device 13. The processor 131 controls each unit to perform various functions of the terminal device 13 based on programs such as firmware, system software, and application software stored in the ROM 132, the auxiliary storage device 134, or the like. The processor 131 executes processing described later based on the programs. The processor 131 is, for example, a central processing unit (CPU), micro processing unit (MPU), system on a chip (SoC), digital signal processor (DSP), graphics processing unit (GPU), application specific integrated circuit (ASIC), programmable logic device (PLD), field-programmable gate array (FPGA), or the like. Alternatively, the processor 131 is a combination of a plurality of these components.

The ROM 132 is a non-volatile read-only memory. The ROM 132 stores, for example, firmware, among the programs described above. The ROM 132 also stores data used by the processor 131 in performing various types of processing.

The RAM 133 is memory used by the processor 131 for reading and writing data. The RAM 133 is used as a work area for storing data that is temporarily used by the processor 131 in performing various types of processing. The RAM 133 is typically a volatile memory.

The auxiliary storage device 134 is, for example, an electric erasable programmable read-only memory (EEPROM), a hard disk drive (HDD), or a flash memory. The auxiliary storage device 134 stores, for example, system software and application software among the programs described above. The auxiliary storage device 134 also stores data used by the processor 131 in performing various types of processing, data generated by the processing in the processor 131, various setting values, and the like.

The touch panel 135 includes, for example, a liquid crystal display or an organic electro-luminescence (EL) display and a pointing device that accepts a touch input. The display provided on the touch panel 135 displays a screen for informing an operator of the shopping cart 10 of various types of information. The touch panel 135 functions as an input device that receives a touch operation by the operator.

The wireless communication circuit 136 is, for example, a circuit for wireless communication. The wireless communication circuit 136 includes an antenna for wireless communication.

The power receiving I/F 137 is an interface circuit to which current is supplied from the mobile battery 15 or the like.

The terminal device 13 is powered by the current input via the power receiving I/F 137 or the current supplied by a built-in battery.

The bus 138 includes a control bus, an address bus, a data bus, and the like for conveying signals transmitted by each unit of the terminal device 13 to another unit.

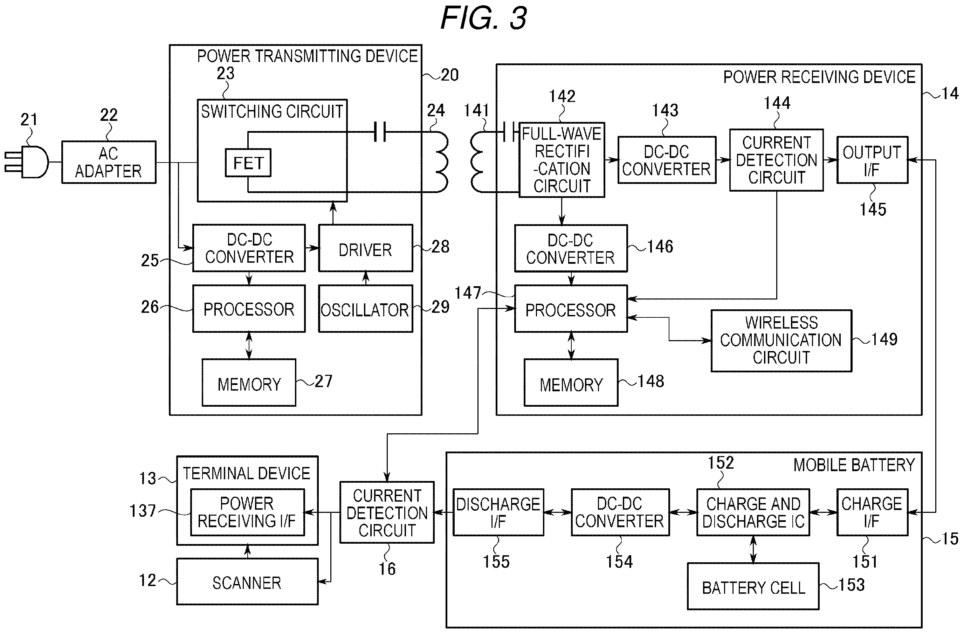

The power receiving device 14, the mobile battery 15, the power transmitting device 20, and the like will be further described with reference to FIG. 3. FIG. 3 is a circuit diagram of the cart system 1 according to an embodiment.

The power transmitting device 20 includes, for example, an outlet 21, an alternating current (AC) adapter 22, a switching circuit 23, a power transmitting coil 24, a direct current (DC)-DC converter 25, a processor 26, a memory 27, a driver circuit 28, and an oscillator 29.

The power transmitting device 20 receives power supplied from a commercial power source or the like via the outlet 21, for example.

The AC adapter 22 converts an alternating current input through the outlet 21 into a direct current and outputs the direct current to the switching circuit 23 and the DC-DC converter 25.

The switching circuit 23 outputs the current input from the AC adapter 22 to the power transmitting coil 24. The switching circuit 23 includes a switch that switches ON/OFF of the current output to the power transmitting coil 24.

The power transmitting coil 24 transmits power to a power receiving coil 141 of the power receiving device 14 by wireless power transmission using electromagnetic induction or the like.

The DC-DC converter 25 converts an input voltage from the AC adapter 22 to a voltage to be applied to the processor 26 and the driver circuit 28.

The processor 26 performs processing necessary for the operation of the power transmitting device 20 and control of each unit. The processor 26 is, for example, a CPU, MPU, SoC, DSP, GPU, ASIC, PLD, FPGA, or the like. Alternatively, the processor 26 is a combination of a plurality of these components.

The memory 27 is a main memory accessed by the processor 26. The memory 27 stores, for example, a program executed by the processor 26. The memory 27 also stores, for example, data used by the processor 26.

The driver circuit 28 switches ON/OFF of the switch of the switching circuit 23 based on the control by the processor 26.

The oscillator 29 generates a clock pulse and input the clock signal to the driver circuit 28.

The power receiving device 14 includes, for example, a power receiving coil 141, a full-wave rectification circuit 142, a DC-DC converter 143, a current detection circuit 144, an output I/F 145, a DC-DC converter 146, a processor 147, a memory 148, and a wireless communication circuit 149.

The power receiving coil 141 receives the power transmitted wirelessly from the power transmitting coil 24 of the power transmitting device 20. The current generated in the power receiving coil 141 is input to the full-wave rectification circuit 142.

The full-wave rectification circuit 142 full-wave-rectifies the current generated in the power receiving coil 141 and outputs the full-wave-rectified current to the DC-DC converter 143 and the DC-DC converter 146.

The DC-DC converter 143 converts the voltage input from the full-wave-rectification circuit 142 to the voltage to be output to the current detection circuit 144.

The current detection circuit 144 outputs the current input from the DC-DC converter 143 to the output I/F 145. The current detection circuit 144 measures the current amount input to the current detection circuit 144 and output from the current detection circuit 144. The current input to the output I/F 145 is fed to the mobile battery 15. Accordingly, the current detection circuit 144 can measure the current amount input to the mobile battery 15. Then, the current detection circuit 144 outputs a charge amount signal indicating the measured current amount to the processor 147.

The output I/F 145 is an interface circuit for outputting power to another device outside the power receiving device 14, such as a detachable battery.

The DC-DC converter 146 converts the voltage input from the full-wave-rectification circuit 142 to the voltage to be output to the processor 147.

The processor 147 performs processing necessary for the operation of the power receiving device 14 and control of each unit. The processor 147 is, for example, a CPU, MPU, SoC, DSP, GPU, ASIC, PLD, FPGA, or the like. Alternatively, the processor 147 is a combination of a plurality of these components.

The memory 148 is a main memory accessed by the processor 147. The memory 148 stores, for example, a program executed by the processor 147. The memory 148 also stores, for example, data used by the processor 147.

The wireless communication circuit 149 is, for example, a circuit for wireless communication. The wireless communication circuit 149 includes an antenna for wireless communication.

The mobile battery 15 includes, for example, a charge I/F 151, a charge and discharge integrated circuit (IC) 152, a battery cell 153, a DC-DC converter 154, and a discharge I/F 155.

The charge I/F 151 is an interface circuit through which current is input to the mobile battery 15.

The charge and discharge IC 152 controls charge and discharge of the battery cell 153. The charge and discharge IC 152 charges the battery cell 153 using the current input to the charge I/F 151. The charge and discharge IC 152 supplies the current discharged from the battery cell 153 to the DC-DC converter 154. The charge and discharge IC 152 functions to prevent the battery cell 153 from being overcharged and over-discharged, for example.

The mobile battery 15 includes one or more battery cells 153. Each battery cell 153 stores electric power (electric charge). Each battery cell 153 discharges the stored power as needed. The battery cell 153 is, for example, a lithium ion battery cell or the like.

The DC-DC converter 154 converts the voltage output from the charge and discharge IC 152 to the voltage to be output to the discharge I/F 155.

The discharge I/F 155 is an interface circuit for outputting current from the mobile battery 15.

The current detection circuit 16 outputs the current from the discharge I/F 155 of the mobile battery 15 to the scanner 12 and the power receiving I/F 137 of the terminal device 13. The current detection circuit 16 measures the amount of current (e.g. a current level value) which is being input to the current detection circuit 16 and/or output from the current detection circuit 16. Accordingly, the current detection circuit 16 measures the amount of the current being output by the mobile battery 15. Then, the current detection circuit 16 outputs a discharge amount signal to the processor 147 indicating the measured amount of current being discharged by the mobile battery 15.

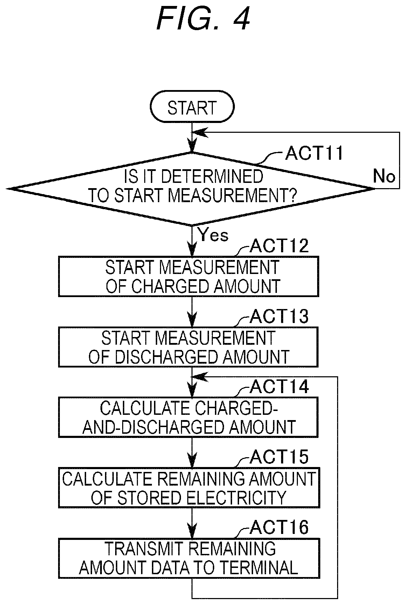

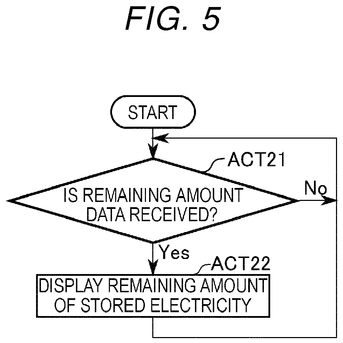

In the following, the operation of the cart system 1 according to an embodiment will be described with reference to FIGS. 4 and 5. The steps of the processing in the following description are examples, and any other steps leading to the same result may be used. FIG. 4 is a flowchart illustrating processing carried out by the processor 147 of the power receiving device 14. The processor 147 carries out this processing by executing, for example, a program stored in the memory 148 or the like.

FIG. 5 is a flowchart illustrating processing by the processor 131 of the terminal device 13. The processor 131 carries out this processing by executing, for example, a program stored in the ROM 132, the auxiliary storage device 134, or the like.

The processor 147 of the power receiving device 14 starts the processing illustrated in FIG. 4, for example, when the power receiving device 14 starts its operation.

In ACT 11 of FIG. 4, the processor 147 of the power receiving device 14 determines whether to start measurement for charge and discharge operations.

For example, when the processor 147 detects that the mobile battery 15 is fully charged, the processor 147 determines to start the measurement. The processor 147 may detect that the mobile battery 15 is fully charged even when the amount of stored charge of the mobile battery 15 is not the absolute full capacity level of the mobile battery 15. For example, the processor 147 may detect that the mobile battery 15 is fully charged when the remaining amount of the stored charge of the mobile battery 15 is equal to or greater than some predetermined amount that is less than a full charge level. Any known method may be used for checking whether the mobile battery 15 is fully charged. For example, charging of the mobile battery 15 can be stopped by the function of the charge and discharge IC 152 to prevent overcharge or the like. When such a function is activated, no current flows to the mobile battery 15. Accordingly, the processor 147 may detect that the current has been stopped from flowing to the mobile battery 15 and may regard that the mobile battery 15 is now fully charged on this basis. Alternatively, the processor 147 may detect the full charge of the mobile battery 15 by monitoring the voltage output from the mobile battery 15.

Alternatively, when the processor 147 detects that the mobile battery 15 is empty (fully discharged or substantially so), the processor 147 determines to start the measurement for charge and discharge operations. For the processor 147 to detect that the mobile battery 15 is empty, the remaining amount of stored electricity in the mobile battery 15 does not necessarily need to be completely zero. For example, the processor 147 may determine that the mobile battery 15 amount is "empty" when the remaining amount of stored charge in the mobile battery 15 is less than or equal to some predetermined amount greater than a zero (no charge) level. Any known method can be used to determine whether the remaining amount of stored charge of the mobile battery 15 is empty. For example, the discharge of the mobile battery 15 can be stopped by the function of the charge and discharge IC 152 to prevent over-discharge or the like. When such a function is activated, the mobile battery 15 does not output current. Accordingly, the processor 147 may detect that the mobile battery 15 has stopped outputting current and may regard the mobile battery 15 as empty on this basis. Alternatively, the processor 147 may detect the mobile battery 15 is empty by monitoring the voltage output from the mobile battery 15.

Alternatively, when the processor 147 detects that the mobile battery 15 is full or empty, the processor 147 determines to start the measurement for the charge and discharge operations.

When the processor 147 determines to start the measurement (ACT 11, YES), the process proceeds to ACT 12. In contrast, when the processor 147 determines not to start the measurement (ACT 11, NO), ACT 11 is repeated.

In ACT 12, the processor 147 starts measuring the current flowing into the mobile battery 15 to measure the amount of charge flowing into the mobile battery 15. The processor 147 controls, for example, the current detection circuit 144 to start measuring the current flowing into the mobile battery 15. The charge amount signal output from the current detection circuit 144 indicates, for example, the measured level of the current flowing after the starting time point of ACT 12 and permits the processor 147 to measure the cumulative charge (charged amount) supplied to the mobile battery 15.

Alternatively, the current detection circuit 144 tracks the current flowing into the mobile battery 15 from some time point before the current amount measurement starting time point of ACT 12 and supplies a cumulative or integrated current flow amount value (from the previous point in time to the measurement starting time point of ACT 12) to the processor 147 at the start of ACT 12. In such a case, the processor 147 stores this cumulative charge amount as indicated by the charge amount signal at the current amount measurement starting time point. As such, the processor 147 can calculate the charge amount flowing to the mobile battery 15 after the current amount measurement starting time point (ACT 12) by subtracting this stored value from the current charged amount indicated by the charge amount signal.

The amount of current can be measured, for example, in units of ampere hours or coulombs.

In ACT 13, the processor 147 starts measuring the current flowing out from the mobile battery 15 to measure the amount of charge flowing out of the mobile battery. The processor 147 controls, for example, the current detection circuit 16 to start measuring the current flowing from the mobile battery 15. The discharge amount signal output from the current detection circuit 16 indicates, for example, the measured level of the current flowing after the starting time point of ACT 13.

Alternatively, the current detection circuit 16 tracks the current flowing from the mobile battery 16 from some time point before the current amount measurement starting time point of ACT 13 and supplies a cumulative or integrated current flow amount value (from the previous point in time to the measurement starting time point of ACT 13) to the processor 147 at the start ACT 13. In such a case, the processor 147 stores in the memory 148 this cumulative charge as indicated by the discharge amount signal at the current amount measurement starting time point. As such, the processor 147 can calculate the charge amount flowing from the mobile battery 15 after the measurement starting point time by subtracting this stored value from the current discharged amount indicated by the discharge amount signal.

Accordingly, the processor 147 starts the measurements of the charged amount and the discharged amount in cooperation with the current detection circuit 144 and the current detection circuit 16.

In ACT 14, the processor 147 calculates the net amount of current charged to and discharged from the mobile battery 15 (hereinafter referred to as "the charged-and-discharged amount"). The charged-and-discharged amount is calculated by subtracting the discharged current amount from the mobile battery 15 from the charged current amount into the mobile battery 15. That is, the processor 147 calculates the charged-and-discharged amount for the mobile battery 15 based on a measurement value for the current flowing into the mobile battery 15 (obtained by the processing of ACT 12) and a measurement value for current flowing out from the mobile battery 15 (obtained by the processing of ACT 13).

In ACT 15, the processor 147 calculates the remaining amount of stored charge for the mobile battery 15 by subtracting the charged-and-discharged amount calculated in ACT 14 from the storage capacity of the mobile battery 15. Alternatively, if the charged-and-discharged amount measurement is started when the mobile battery 15 is empty, the processor 147 sets the charged-and-discharged amount as the remaining amount of stored charge. The storage capacity of the mobile battery 15 can be input to the cart system 1 in advance by an administrator, seller, service person, or the like of the cart system 1. Alternatively, the storage capacity value of the mobile battery 15 may be calculated or estimated by various methods. The processor 147 stores the input storage capacity in the memory 148, for example. The storage capacity of the mobile battery 15 is typically described on, for example, an outer casing of the mobile battery 15 or in manufacturer specifications thereof.

As described above, the processor 147 calculates a value indicating the remaining amount of stored charge by performing processing of ACT 15.

In ACT 16, the processor 147 instructs the wireless communication circuit 149 to transmit remaining amount data to the terminal device 13. The remaining amount data includes the remaining amount of stored electricity (charge) calculated in ACT 15. Upon receiving this transmission instruction, the wireless communication circuit 149 transmits the remaining amount data to the terminal device 13. The transmitted remaining amount data is received by the wireless communication circuit 136 of the terminal device 13. After processing of ACT 16, the processor 147 returns to ACT 14. Accordingly, the processor 147 repeats ACT 14 to ACT 16 to periodically calculate the remaining amount of stored charge of the mobile battery 15, and transmits the calculated remaining amount to the terminal device 13.

With reference to FIG. 5, the processor 131 of the terminal device 13 waits for the remaining amount data to be received by the wireless communication circuit 136 in ACT 21. When the remaining amount data is received, the processor 131 determines that the determination result in ACT 21 is YES and proceeds to ACT 22.

In ACT 22, the processor 131 controls the touch panel 135 to display the remaining amount of stored charge indicated by the remaining amount data. After processing of ACT 22, the processor 131 returns to ACT 21.

According to the cart system 1 of an embodiment, the power receiving device 14 measures the current charged amount and the current discharged amount of the mobile battery 15 so that the power receiving device 14 can calculate the remaining amount of stored charge of the mobile battery 15.

The power receiving device 14 outputs the calculated remaining amount of stored charge in the mobile battery 15. The output remaining amount is input to the terminal device 13 and displayed on the touch panel 135 of the terminal device 13, for example. Accordingly, the operator or the administrator of the shopping cart 10 can know the remaining amount of stored charge of the mobile battery 15.

According to the cart system 1 of an embodiment, the power receiving device 14 receives power wirelessly. Since there can be many locations in a store where the battery can be charged, the power receiving device 14 can reduce the frequency of running out of the battery of the mobile battery 15.

The embodiments described above can be modified as follows.

In the embodiments described above, power feeding from the power transmitting device 20 to the power receiving device 14 is made through wireless power transmission. However, power feeding from the power transmitting device to the power receiving device may be made through wired power transmission.

In the embodiments described above, the current detection circuit 144 and the current detection circuit 16 are circuits that measure the present (instantaneous) amount of current flowing to or out from the mobile battery 15. However, the current detection circuit 144 and the current detection circuit 16 may be circuits that measure a cumulative current transfer value. That is, the current detection circuit 144 and current detection circuit 16 may output a cumulative (or net) current transfer value instead of the present amount of current flow. The processor 147, for example, integrates the instantaneous current flow to and out from the mobile battery 15 over time to provide a net current transfer value based on the measured current value and the time elapsed for the current flows.

In the embodiments described above, the storage capacity of the mobile battery 15 is a parameter input in advance. However, the power receiving device 14 may also measure the storage capacity of the mobile battery 15. For example, the power receiving device 14 calculates the storage capacity of the mobile battery 15 by tracking the charged-and-discharged amount from when the mobile battery 15 is empty to when the storage capacity of the mobile battery 15 is fully charged. This eliminates the need to input the storage capacity of the mobile battery 15 in advance.

The power receiving device 14 may calculate the storage capacity of the mobile battery 15 regularly or irregularly. With such a configuration, the power receiving device 14 can prevent decrease in accuracy for calculating the remaining amount of stored charge due to the changes in the storage capacity of the mobile battery 15 over time caused by aging or other deterioration.

In the embodiments described above, the terminal device 13 displays the remaining amount of stored charge in the mobile battery 15. However, the terminal device 13 may indicate the remaining amount of stored charge by another method such as outputting sound from a speaker.

Also, a device other than the terminal device 13 may indicate the remaining amount of stored charge in the mobile battery 15. For example, the cart body 11 or the power receiving device 14 may be provided with a device such as a display or a speaker that informs the remaining amount of stored charge in the mobile battery 15.

The power receiving device 14 or the terminal device 13 may transmit the remaining amount of the stored charge to an apparatus outside the shopping cart 10, such as a server apparatus. In such a case, the server apparatus may inform the remaining amount of the stored charge using, for example, a display such as a console or a speaker. With such a configuration, a store clerk or the like can monitor the remaining amount of stored charge of the mobile battery 15 for each shopping cart 10 used in the store.

The processor 131 of the terminal device 13 may perform part or all of the processing executed by the processor 147 of the power receiving device 14 in the embodiments described above.

In the aforementioned embodiments, the cart system 1 using the shopping cart 10 is described. However, the embodiments can be applied to other cart systems using a cart other than the shopping cart 10, e.g., a cart for moving goods from stock, a cart for carrying luggage, or the like. Additionally, the aforementioned embodiments can be applied to any measurement system that does not use a cart but relies on mobile batteries or the like. Furthermore, such a measurement system may be configured to supply power to various devices other than the terminal device 13.

The measurement system of the aforementioned embodiments may use a storage capacitor instead of a mobile battery 15.

A part or all of the processing executed by the processor 131 and the processor 147 according to the embodiments described above may be performed by hardware such as a circuit.

Each device in the embodiments described above can be transferred to, for example, an administrator of each device with a program for executing each type of processing described above already stored therein. Alternatively, each device can be transferred to an administrator or the like with the program not already stored therein. In such a case, the program can be separately provided to the administrator or the like, and then stored in each device based on the operation by the administrator or a service person. In such a case, the program may be copied from a removable storage medium such as a disk medium or a semiconductor memory, or downloaded via the Internet or LAN.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the embodiments described herein may be made without departing from the scope of the inventions. The accompanying claims and their equivalents are intended to cover such forms or modifications as would fall within the scope of the inventions.

## Claims

1. A measurement apparatus, comprising:
a measurement circuit configured to measure a first current that flows to an electricity storage device and a second current that flows from the electricity storage device; and
a processor configured to detect at least one of a first state, in which the electricity storage device is fully charged, and a second state, in which the electricity storage device is fully discharged, wherein
the processor is further configured to:
upon detection of said one of the first and second states, control the measurement circuit to start measurement of the first current and the second current,
calculate a remaining amount of charge in the electricity storage device based on the measured first current and the measured second current, and
output the calculated remaining amount of charge.

2. The measurement apparatus according to claim 1, further comprising an electromagnetic induction coil, wherein
the measurement circuit measures the first current flowing from the electromagnetic induction coil to the electricity storage device.

3. The measurement apparatus according to claim 1 or 2, further comprising a memory that stores a storage capacity value for the electricity storage device.

4. The measurement apparatus according to claim 3, wherein the remaining amount of charge of the electricity storage device is calculated based on the storage capacity value stored in the memory.

5. The measurement apparatus according to claim 3, wherein the processor is configured to:
detect both the first and second states, and
calculate the storage capacity value using time-integrated values of the first current and the second current as measured for a change between the first and second states.

6. The measurement apparatus according to any one of claims 1 to 5, further comprising a wireless communication circuit, wherein
the processor is further configured to control the wireless communication circuit to transmit the calculated remaining amount of charge to a terminal device.

7. The measurement apparatus according to any one of claims 1 to 6, further comprising an output interface circuit connected to the measurement circuit, wherein
the first current flows through the output interface circuit to the electricity storage device.

8. The measurement apparatus according to any one of claims 1 to 7, wherein the electricity storage device is a battery.

9. A measurement system, comprising:
a terminal device; and
the measurement apparatus according to any one of claims 1 to 8.

10. The measurement system according to claim 9, wherein the terminal device is configured to display the remaining amount of charge.

11. The measurement system according to claim 9 or 10, further comprising a body frame to which the terminal device, the measurement apparatus, and the electricity storage device are attached.

12. The measurement system according to claim 11, further comprising wheels attached to the body frame.

13. A cart, comprising:
a body frame to which wheels are attached;
a terminal device attached to the body frame;
a battery which is the electricity storage device configured to supply power to the terminal device; and
the measurement apparatus according to any one of claims 1 to 7, attached to the body frame,
wherein the terminal device is configured to display the calculated remaining amount of power.
